# EUROPEAN PATENT APPLICATION

(11) **EP 1 175 004 A1**
(43) Date of publication of application: **23.01.2002**
(21) Application number: 01906209.0
(22) Date of filing: 22.02.2001
(51) Int. Cl.: H03G 3/20

(54) **AUTOMATIC GAIN CONTROL METHOD, AUTOMATIC GAIN CONTROL PROCESSOR, AND DEMODULATOR**

(30) Priority: 28.02.2000 JP 2000051748
(71) Applicant: MITSUBISHI DENKI KABUSHIKI KAISHA, Tokyo 100-8310 (JP)
(72) Inventor: HAYASHI, Ryoji Mitsubishi Denki Kabushiki Kaisha, Chiyoda-ku, Tokyo 100-8310 (JP)
(74) Representative: Pfenning, Meinig & Partner
(86) International application number: JP0101303
(87) International publication number: WO0165686

(57) **Abstract**

An automatic gain control method is provided in which, even when an input power level of a received radio signal is increased abruptly, saturation of an analog-to-digital converter is cancelled in a short period of time, and in which control is prevented from becoming unstable even when a periodic variation in power level occurs. A DSP determines a differential value by subtracting a power level of the analog-to-digital converter from a reference level. When the differential value is negative, i.e., when a gain of a variable gain amplifier is to be decreased, the DSP controls the gain of the variable gain amplifier, based on a first magnitude of variation in gain determined based on the differential value. When the differential value is positive, i.e., when the gain of the variable gain amplifier is to be increased, the DSP controls the gain of the variable gain amplifier, based on a second magnitude of variation in gain smaller than the first magnitude of variation in gain. With this, even when the input power level the of variable gain amplifier is increased abruptly, the magnitude of increase in the output power level of the variable gain amplifier is suppressed.

## Description

### Technical Field

The present invention relates to an automatic gain control method for controlling a gain of a variable gain amplifier in a demodulating apparatus for use in a mobile station and/or a base station in a mobile communications system, to an automatic gain control processor implementing the method and to a demodulating apparatus comprising the automatic gain control processor.

### Background Art

A mobile communication systems realizes mobile communication by transmitting and receiving a radio signal between mobile stations and base stations. Each of the stations recovers original data by demodulating a received radio signal by a demodulating apparatus. Generally, the station performs the demodulating process after converting the received radio signal into a digital signal using an A/D converter.

The power level of the received radio signal varies so that the, depending on the magnitude of variation, saturation may occur in the A/D converter or the received radio signal is drowned in quantizing noise occurring in the A/D converter. To resolve this problem, the demodulating according to the related art is provided with an automatic gain control (AGC) circuit (hereinafter, referred to as AGC circuit) so that the power level of the received radio signal is maintained at a constant level by the AGC circuit. The demodulating of such a configuration is disclosed in Soeya, Ueno and Tsurumi, "Direct Conversion Receiver with Baseband AGC", Institute of Electronics, Information and Communications Engineers 1993 Spring Convention, B-322.

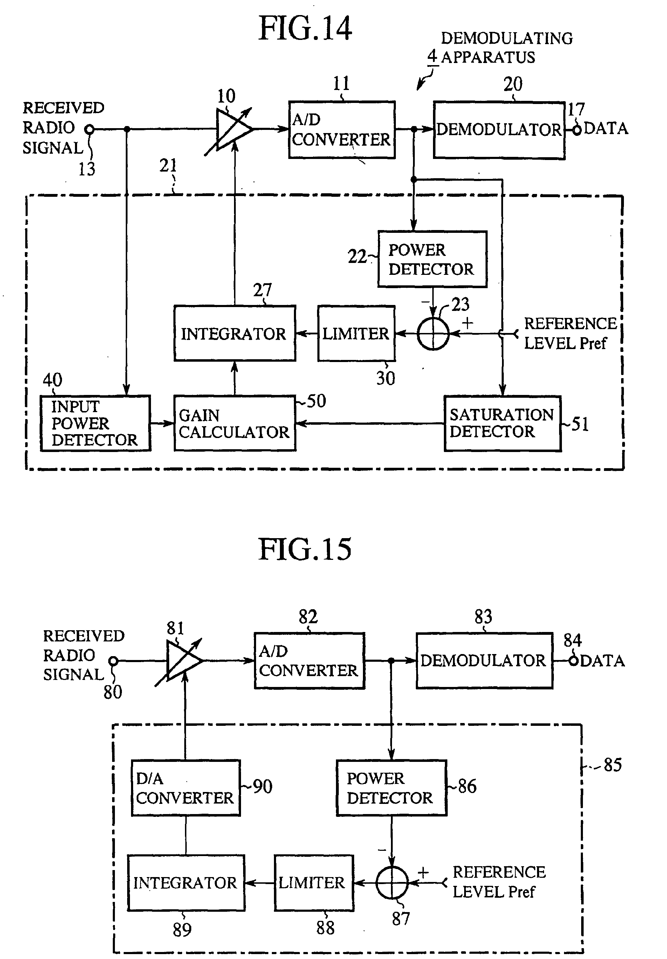

Fig. 15 is a block diagram showing a construction of the demodulating apparatus shown in the above-mentioned reference. The demodulating apparatus amplifies the received radio signal received via an input terminal 80 by a variable gain amplifier 81 and then converts the signal into a digital received radio signal by quantizing the signal by an A/D converter 82. The demodulating apparatus recovers the original data by demodulating the digital received radio signal by a demodulator 83 so that the original data is output via an output terminal 84. An AGC circuit 85 automatically controls the gain of the variable gain amplifier 81 in accordance with a difference between the power level of the received radio signal output from the A/D converter 82 and a predetermined reference level Pref, so that the power level of the received radio signal fed to the demodulator 83 is maintained at a constant level.

More specifically, the AGC circuit 85 detects the power level of the received radio signal by a power detector 86. The power detector 86 detects the power level by obtaining a sum of squares of the received radio signal over a predetermined period designed to determine a mean power (power averaging period). A subtractor 87 of the AGC circuit 85 determines a differential value by subtracting the detected power level from the reference level. Further, a multiplier 87 of the AGC circuit 85 multiplies the differential value by a constant so that an integrator 89 perform integration. A D/A converter 90 of the AGC circuit 85 converts the integrated value into an analog voltage so as to feed the analog voltage to the variable gain amplifier 81.

With this construction, when the power level of the received radio signal input to the A/D converter 82 becomes larger than the reference level, the differential value becomes a negative value. As a result of the differential value being multiplied by a constant and subject to integration by the integrator 89, the integrated value is decreased as compared to a previous value. Therefore, the analog voltage output from the D/A converter 90 becomes small so that the gain of the automatic gain amplifier 82 is decreased. Accordingly, the power level of the received radio signal input to the A/D converter 82 drops.

In mobile communication, a signal may undergo fading in which a instantaneous level of the received radio signal abruptly varies. When fading occurs, the power level of the received radio signal varies periodically. When the period of variation substantially matches the power averaging period in the power detector 86, control by the AGC circuit becomes unstable.

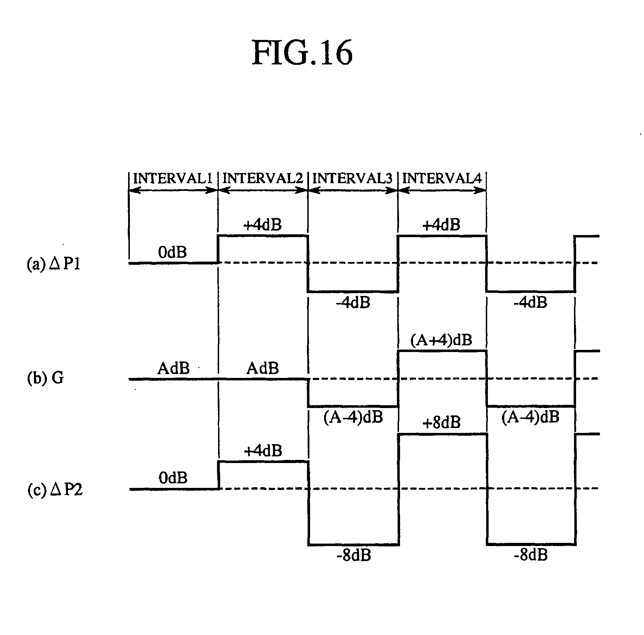

(a), (b) and (c) of Fig. 16 respectively show a difference ΔP1 between the reference level Pref and the power level of the received radio signal input via the input terminal 80 (hereinafter, referred to as input power level), a gain G of the variable gain amplifier 81, and a difference ΔP2 between the reference level Pref and the power level of the received radio signal output from the. variable gain amplifier 81 (hereinafter, referred to as output power level). Referring to Fig. 16, the constant of 1 is set in the multiplier 88.

Given that the period of level variation matches the power averaging period, gain G of'the variable gain amplifier 81 in interval 2 is set to be equal to the previous gain A in interval 1, when the power level detected by the power detector 86 in interval 1 is equal to the reference level Pref.

When the input power level rises to a level 4 dB higher than the reference level Pref in interval 2, the output power level of the variable gain amplifier 81 rises to a level 4 dB higher than the reference level Pref since gain G of the variable gain amplifier 81 remains the same as that of interval 1. For this reason, the power level detected by the power detector 86 in interval 2 is 4 dB higher than the reference level. As a result, gain G of the variable gain amplifier 81 in interval 3 is set to a level (A-4) dB which is 4 dB lower than the previous gain in interval 2.

When the input power level drops to a level 4 dB lower than the reference level in interval 3, the output power level of the variable gain amplifier 81 drops to a level 8 dB lower than the reference level Pref since gain G of the variable gain amplifier 81 is (A-4) dB. The power level detected by the power detector 86 in interval 3 is 8 dB lower than the reference level so that gain G of the variable gain amplifier 81 in interval 4 is set to be 8 dB higher than the previous gain in interval 3. That is, gain G of the variable gain amplifier 81 in interval 4 is (A+4) dB.

Subsequently, as the input power level varies periodically in synchronization with the power averaging period, the output power level varies periodically by ±8 dB. Since the input power level varies ±4 dB, the amplitude of variation in the output power level is larger than the amplitude of variation in the input power level. Thus, in a condition in which the period of level variation substantially matches the power averaging period, the variation in gain of the variable gain amplifier 81 is synchronized with the variation in the input power level so that the magnitude of variation of the output power level becomes larger than the magnitude of variation in the input power level, rendering the control unstable.

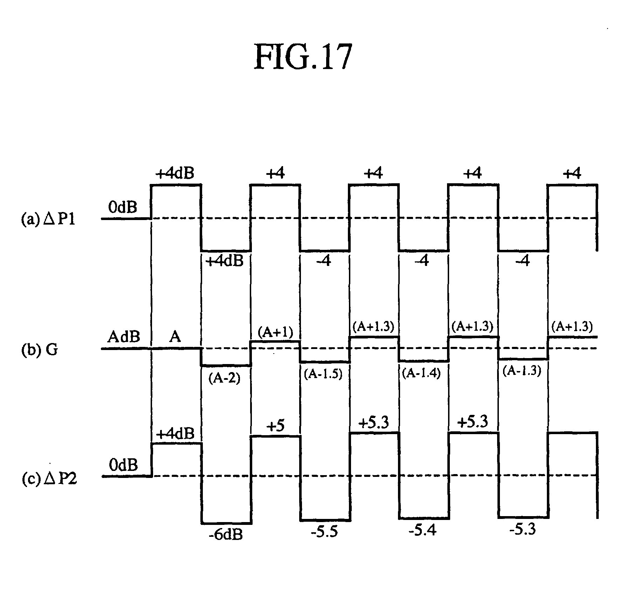

This can be dealt with by preventing the difference between the power level and the reference level from being used as the magnitude of variation in the gain of the variable gain amplifier 81 and by multiplying the differential value by a coefficient smaller than 1 in the multiplier 87, so as to suppress the variation in gain. For example, given that the coefficient of 0.5 is employed in a condition in which the input power level varies as shown in Fig. 17, the output power level of the variable gain amplifier 81 varies periodically by ± 5.3 dB. Compared with the 8 dB variation of Fig. 16, the magnitude of variation is suppressed.

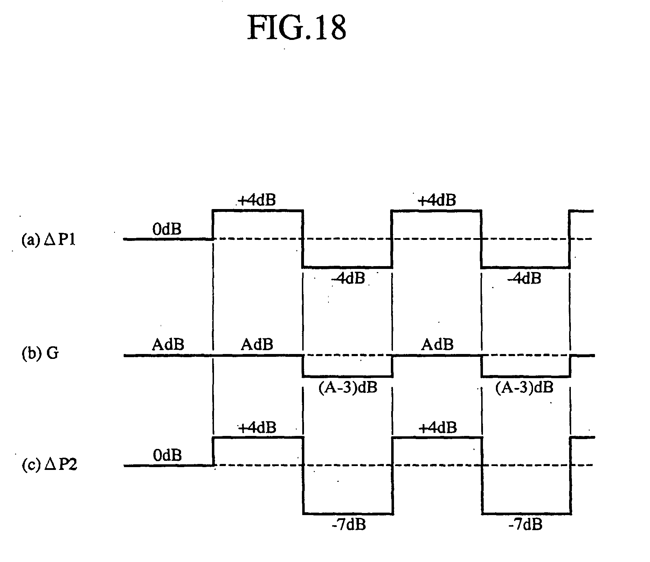

Alternatively, a limiter may be provided in place of the multiplier 88 so that the magnitude of variation in gain is controlled to be below a certain level. When the magnitude of variation is controlled by the limiter to be smaller than 3 dB, the output power level of the variable gain amplifier 81 periodically increases and decreases to a +4 dB level and a -7 dB level, as shown in Fig. 18. Thus, the magnitude of variation is suppressed as compared to the 8 dB variation of Fig. 16.

These approaches, however, are all designed to suppress the magnitude of variation so that, when the input level varies significantly in steps, a relatively long period of time is required for the gain of the variable gain amplifier 81 to return to the reference level. For example, the input level may vary in steps when a user using a communication service on a train or a vehicle exits a tunnel. In this case, the input level of the A/D converter 82 is increased abruptly. When the increase is beyond a quantization range, saturation occurs. When saturation occurs, the received signal exhibits a rapid large-scale distortion. What happens in this case is that, despite the fact that a signal at a level sufficiently high for demodulation is received, demodulation cannot not takes place until the signal input to the A/D converter 82 drops to an appropriate level. For example, a period of 60-70 msec is required for the input signal to drop to an appropriate level.

When the input power level drops abruptly, the aforementioned problem does not occur. More specifically, when the input power level.drops, the SN ratio drops accordingly. The speed at which the SN ratio drops is significantly lower than that of signal transmission. When the input power level drops, the SN ratio only drops accordingly. Therefore, the quality of reception suffers less as compared to a case where the input power level is increased abruptly and the quality of reception suffers at a magnitude larger than the magnitude of increase.

### Disclosure of the Invention

The present invention has been developed in this technical background and has an objective of providing an automatic gain control method, automatic gain control processor and demodulating apparatus in which saturation of an A/D converter, occurring when an input power level of a received radio signal is abruptly increased, is immediately canceled, and in which control is prevented from becoming unstable even when a periodical level variation occurs.

The aforementioned objective is achieved by an automatic gain control method for automatically controlling a gain of a variable gain amplifier, based on a difference between a predetermined reference level and a power level of a received radio signal digitized by an analog-to-digital converter subsequent to amplification by the variable gain amplifier, wherein the gain of the variable gain amplifier is controlled such that a magnitude of variation in gain for a case where the power level is lower than the reference level is controlled to be smaller than that of a case where the power level is higher than the reference level.

The aforementioned objects is also achieved by an automatic gain control processor comprising a variable gain amplifier, an analog-to-digital converter and connection terminals connected to the variable gain amplifier and the analog-to-digital converter, for automatically controlling a gain of the variable gain amplifier via the connection terminals, based on a difference between a power level of a received radio signal input from the analog-to-digital converter via the connection terminals and a reference level, wherein the gain of the variable gain amplifier is controlled such that a magnitude of variation in gain for a case where the power level is lower than the reference level is controlled to be smaller than that of a case where the power level is higher than the reference level.

The aforementioned objective is also achieved by a demodulating apparatus comprising: a variable gain amplifier for amplifying a received radio signal; an analog-to-digital converter for digitizing the received radio signal amplified by the variable gain amplifier and outputting the digital signal; and an automatic gain control processor executing a step of demodulating the received radio signal output from the analog-to-digital converter, and a step of controlling a gain of the variable gain amplifier such that a magnitude of variation in gain for a case where a power level of the received radio signal output from the analog-to-digital converter is lower than a reference level is controlled to be smaller than that of a case where the power level is higher than the reference level.

In accordance with the construction of the invention, a gain of a variable gain amplifier is controlled such that a magnitude of variation in gain for a case where the power level is lower than the reference level is controlled to be smaller than that of a case where the power level is higher than the reference level. Accordingly, even when the period of variation in level caused by fading matches the power averaging period, and when the input power level is increased abruptly in steps as a result of, for example, exiting from a tunnel, the magnitude of increase in the output power level of the variable gain amplifier is suppressed. For this reason, saturation of an A/D converter, if it occurs, is canceled immediately. Since the magnitude of increase in he output power level of the variable gain amplifier is suppressed, control is stabilized.

By implementing gain control by an automatic gain control processor, occurrence of noise on a signal line or the like is avoided in contrast to a configuration in which the gain control process is implemented by hardware.

In a demodulating apparatus according to the invention, an automatic gain control processor controls a gain of a variable gain amplifier such that a magnitude of variation in gain for a case where a power level is lower than a reference level is controlled to be smaller than that of a case where the power level is higher than the reference level. Therefore, saturation occurring in an A/D converter is immediately canceled so that the period of time in which demodulation is disabled is significantly shortened.

### Brief description of the drawings

Fig. 1 is a schematic diagram showing an overall construction of a mobile communications system to which an automatic gain control method according to a first embodiment of the present invention is applied;
Fig. 2 is a block diagram showing an internal construction of a demodulating apparatus;
Fig. 3 is a flowchart showing a gain control process;
Fig. 4 is a diagram showing a variation in an output power level of a variable gain amplifier;
Fig. 5 is a graph showing a variation in an output power level of a variable gain amplifier;
Fig. 6 is a block diagram showing a construction of a demodulating apparatus in which a demodulating process and a gain control process are implemented by hardware;
Fig. 7 is a flowchart showing a gain control process in a DSP to which an automatic gain control method according to a second embodiment of the present invention is applied;
Fig. 8 is a diagram showing a variation in an output power level of a variable gain amplifier;
Fig. 9 is a block diagram showing a construction of a demodulating apparatus in which a demodulating process and a gain control process are implemented by hardware;
Fig. 10 is a flowchart showing a variation 'of a gain control process;
Fig. 11 is a flowchart showing a saturation gain control process performed by a DSP in the event of saturation, to which process an automatic gain control method according to a third embodiment of the present invention is applied;
Fig. 12 is a block diagram showing a construction of a demodulating apparatus in which a demodulating process and a gain control process are implemented by hardware;
Fig. 13 is a flowchart showing a saturation gain control process performed by a DSP in the event of saturation, to which process an automatic gain control method according to a fourth embodiment of the present invention is applied;
Fig. 14 is a block diagram showing a construction of a demodulating apparatus in which a demodulating process and a gain control process are implemented by hardware;
Fig. 15 is a block diagram showing a construction of a demodulating apparatus according to the related art;
Fig. 16 is a diagram showing a variation in an output power level of a variable gain amplifier according to the related art;
Fig. 17 is a diagram showing a variation in an output power level of a variable gain amplifier according to the related art; and
Fig. 18 is a diagram showing a variation in an output power level of a variable gain amplifier according to the related art.

### Best mode for carrying out the invention

Various embodiments according to the invention will be described in detail with reference to the attached drawings.

### First embodiment

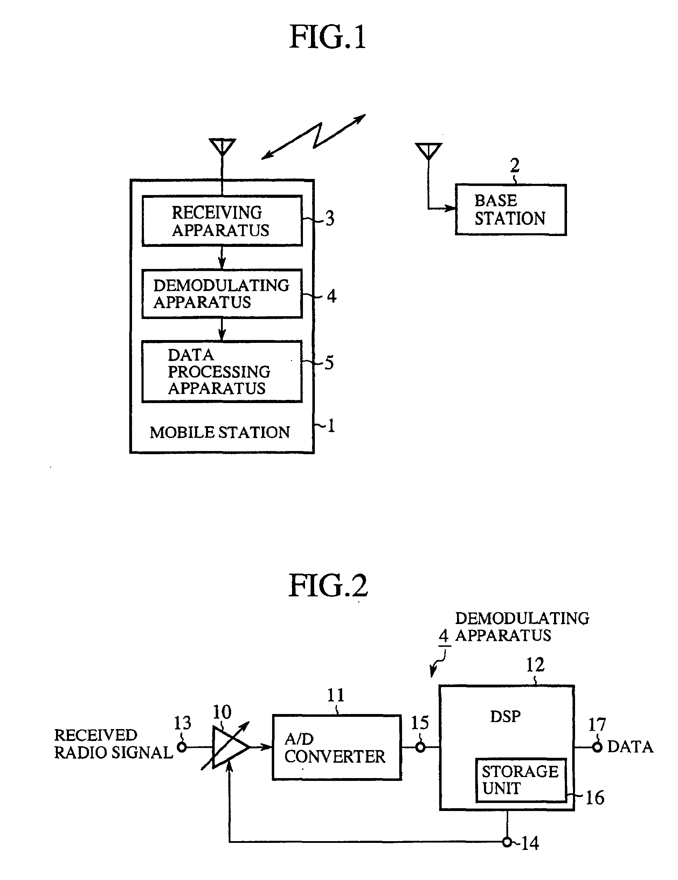

Fig. 1 is a schematic diagram showing an overall construction of a mobile communications system to which an automatic gain control method according to a first embodiment is applied. The mobile communications system comprises a mobile station 1 and a base station 2. Mobile communication is performed by transmitting and receiving a radio signal between the mobile station 1 and the base station 2. More specifically, the base station 2 transmits a radio signal modulated by a predetermined modulation method to the mobile station 1. The mobile station 1 is provided with a receiving apparatus 3 receiving a radio signal and outputting the signal as a received radio signal. The received radio signal output from the receiving apparatus 3 is demodulated by a demodulating apparatus 4. The data demodulated by the demodulating apparatus 4 is processed by a data processing apparatus 5.

Fig. 2 is a block diagram showing an internal construction of the demodulating apparatus 4. The demodulating apparatus 4 is designed to demodulate the received radio signal output from the receiving apparatus 3 so as to recover original data and output the recovered data to the data processing apparatus 5.

More specifically, the demodulating apparatus 4 includes a variable gain amplifier 10, an A/D converter 11 and a digital signal processor (DSP) 12. The variable gain amplifier 10 maintains the received radio signal input via an input terminal 13 of the demodulating apparatus 4 at a predetermined reference level Pref at an output of the variable gain amplifier 10. The received radio signal output from the variable gain amplifier 10 is supplied to the A/D converter 11.

The A/D converter 11 converts the received signal into a digital signal by quantizing the received radio signal within a predetermined dynamic range. The dynamic range is set, for example, to be -5V∼+5V. The A/D converter 11 converts the received radio signal within the dynamic range into a digital signal of 8 bits (-128∼127). The digital received radio signal output from the A/D converter 11 is supplied to the DSP 12.

The DSP 12 uses software to perform a demodulating process for demodulating the received radio signal output from the A/D converter 11 and a gain control process for controlling gain G of the variable gain amplifier 10. More specifically, the DSP 12 is provided with a first connection terminal 14 connected to the variable gain amplifier 10 and a second connection terminal 15 connected to the A/D converter 11. The DSP 12 is provided with a storage unit 16. The storage unit 16 is constituted by, for example, a ROM storing a computer program for the demodulating process and the gain control process. The DSP 12 is operated in accordance with the computer program stored in the storage unit 16. The DSP 12 is provided with an output terminal 17 connected to the data processing apparatus 5 so as to output the data resulting from the demodulating process to the data processing apparatus 5 via the output terminal 17.

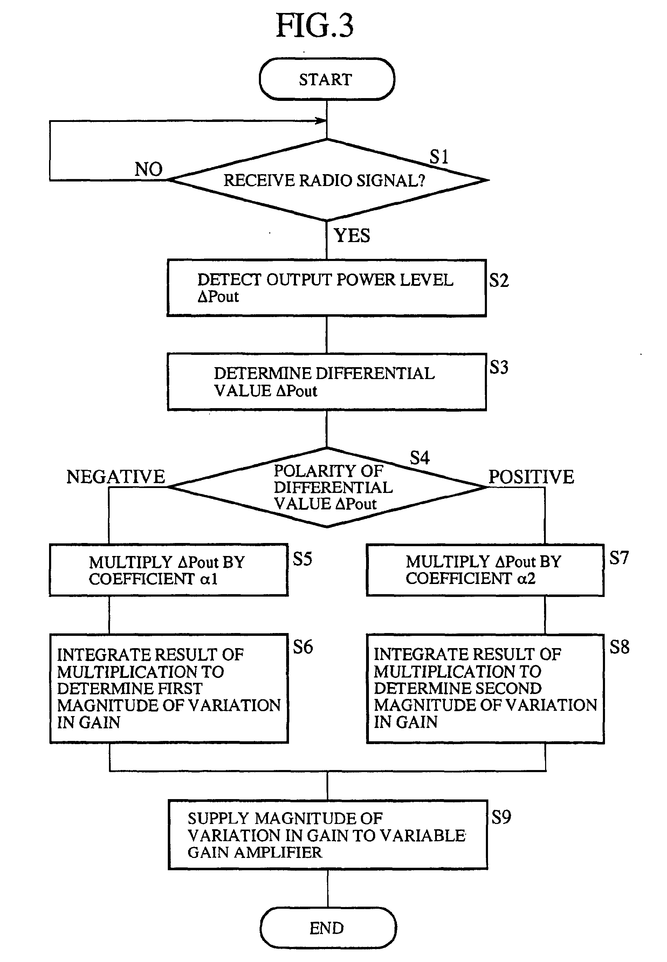

Fig. 3 is a flowchart showing a gain xontrol process. The DSP 12 performs the gain control process in accordance with a difference between the output power level Pout of the received radio signal from the A/D converter 11 and the reference level Pref. The DSP 11 uses feedback control to effect the gain control process.

Upon receiving the received radio signal from the A/D converter 11 (step S1), the DSP 12 detects the output power level Pout of the received radio signal (step S2). More specifically, the DSP 12 determines a sum of squares of the received radio signal in a predetermined period designed to determine a mean power (power averaging period) having a duration of, for example, 10 msec, and outputs the sum as the output power level Pout.

Subsequently, the DSP 12 determines a differential value ΔPout which is a difference between the output power level Pout and the reference level Pref (step S3). More specifically, the DSP 12 determines a positive or negative differential value ΔPout by subtracting the output power level Pout from the reference level Pref. Thus, when the output power level Pout is higher than the reference level Pref, a negative differential value ΔPout is obtained. When the output power level Pout is lower than the reference level Pref, a positive differential value ΔPout is obtained.

That is, a negative differential value ΔPout indicates that the output power level is higher than the reference level Pref. A positive differential value ΔPout indicates that the output power level is lower than the reference level Pref. Subsequently, the DSP 12 multiplies the differential value ΔPout by a predetermined coefficient α so as to determine a magnitude of variation in gain in accordance with the polarity of the differential value ΔPout (steps S4-S8).

The coefficient α includes a first coefficient α1 and a second coefficient α2 provided for respective polarities. The first coefficient α1 is provided for a case where the differential value ΔPout is negative. The second coefficient α2 is provided for a case where the differential value ΔPout is 0 or positive. The first coefficient α1 is greater than 0 and the second coefficient α2, and is equal to or smaller than 1. The second coefficient α2 is greater than 0, equal to or smaller than 1, and smaller the first coefficient α1. For example, the first coefficient α1 and the second coefficient α2 are set to 1.0 and 0.5, respectively. Accordingly, the relationship between the first coefficient α1 and the second coefficient α2 is such that 0<α2<α1≦1.

The DSP 12 determines the polarity of the differential value ΔPout (step S4). When it is determined that the differential value ΔPout is negative, the DSP 12 multiplies the differential value ΔPout by the first coefficient α1 (step S5). Subsequently, the DSP 12 determines a first magnitude of variation in gain by integrating the multiplication result (step S6). The DSP 12 supplies the first magnitude of variation in gain to the variable gain amplifier 10 (step ST9).

When it is determined that the differential value is positive, the DSP 12 multiples the differential value ΔPout by the second coefficient α2 (step S7). Subsequently, the DSP 12 determines a second magnitude of variation in gain by integrating the multiplication result (step S8). The second coefficient α2 is smaller than the first coefficient α1. Therefore, given that the same value of ΔPout is subject to multiplication, the second magnitude of variation in gain is smaller than the first magnitude of variation in gain. The DSP 12 supplies the second magnitude of variation in gain to the variable gain amplifier (step S9).

The variable gain amplifier 10 controls its gain in accordance with the first magnitude of variation in gain or the second magnitude of variation in gain. More specifically, the variable gain amplifier 10 controls its gain by varying its gain by the first magnitude of variation in gain or the second magnitude of variation in gain.

Thus, the DSP 12 multiplies the differential value ΔPout by the coefficient α2 when the differential value ΔPout is positive, the second coefficient being smaller than the coefficient employed when the differential value ΔPout is negative. When the differential value ΔPout is positive, it means that the output power level Pout 'is lower than the reference level Pref so that increase in the output power level Pout is due. When the differential value ΔPout is negative, it means that the output power level Pout is higher than the reference level Pref so that decrease in the output power level Pout is due.

The DSP 12 converts the differential value ΔPout into a smaller value when the gain of the variable gain amplifier 10 is to be increased, and maintains ΔPout unchanged when the gain of the variable gain amplifier is to be decreased. Therefore, the DSP 12 operates to control the magnitude of variation in gain to a relatively low level when the gain is to be increased, and controls the magnitude of variation in gain to a relatively high level when the gain is to be decreased. As a result, an abrupt increase in the output power level Pamp of the variable gain amplifier 10 is suppressed.

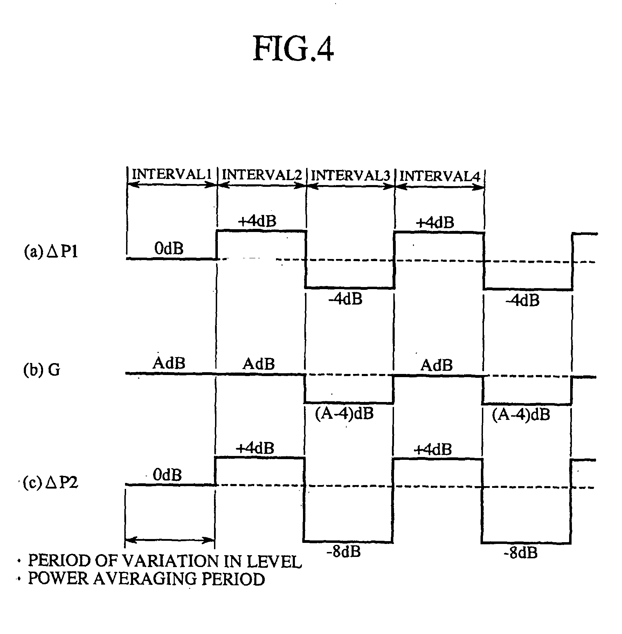

(a), (b) and (c) of Fig. 4 respectively show a difference ΔP1 between the reference level Pref and the power level of the received radio signal input via the input terminal 13 (hereinafter, referred to as input power level), a gain G of the variable gain amplifier, and a difference ΔP2 between the reference level Pref and the output power level Pamp of the variable gain amplifier 10. In Fig. 4, it is assumed that the received signal undergoes fading and that the period of variation in level caused by fading matches the power averaging period.

When the input power level Pin is equal to the reference level Pref, i.e. when the differential value ΔP1 is 0 dB, gain G for a subsequent interval 2 is set to A dB equal to the previous level of gain G for interval 1. When the input power level is increased by 4 dB in the subsequent interval 2, the output power level Pamp of the variable gain amplifier 10 for interval 2 is increased by 4 dB as compared to that of interval 1, since gain G for interval 2 remains A dB, the same level for interval 1. Gain G for interval 3 is set to be (A-4)dB, a level lower than that of interval 2 by a magnitude commensurate with the increase in the power level in interval 2, in order to suppress an increase in interval 3.

When the input power level Pin drops to a level 4 dB lower than the reference level in interval 3, the output power level Pamp of the variable gain amplifier 10 drops to a level 8 dB lower than the reference level, since gain G for interval 3 is (A-4)dB. Accordingly, it is necessary to increase the output power level Pamp of the variable gain amplifier 10 in subsequent interval 4. According to the first embodiment, the magnitude of variation in gain in the increasing direction is controlled to be half that of the decreasing direction. Therefore, the gain is increased by 4 dB instead of 8 dB. That is, gain G for interval 4 is A dB.

When the input power level Pin is increased to a level 4 dB higher than the reference level Pref in interval 4, the output power level Pamp of the variable gain amplifier 10 is increased to a level 4dB higher than the reference level Pref in interval 4, since gain G for interval 4 is A dB. Thus, increase in the output power level Pamp of the variable gain amplifier 10 is suppressed as compared to a case where the magnitude of variation in gain is 8 dB.

Thus, according to the first embodiment, the magnitude of variation in gain in the increasing direction of gain is controlled to be smaller than the magnitude of variation in gain in the decreasing direction of gain. Accordingly, even when the input power level Pin is increased abruptly in steps as a result of, for example, exiting from a tunnel, the magnitude of increase in the output power level Pamp of the variable gain amplifier 10 is suppressed so that saturation of the A/D converter 11 is prevented.

Since the magnitude of variation is relatively large in the decreasing direction of gain, saturation of the A/D converter 11 that may occur is canceled in a short period of time. Accordingly, the period in which demodulation is disabled is shortened. Accordingly, the quality of communication is improved. Since the magnitude of increase in the output power level Pamp of the variable gain amplifier 10 is suppressed, the control becomes more stable.

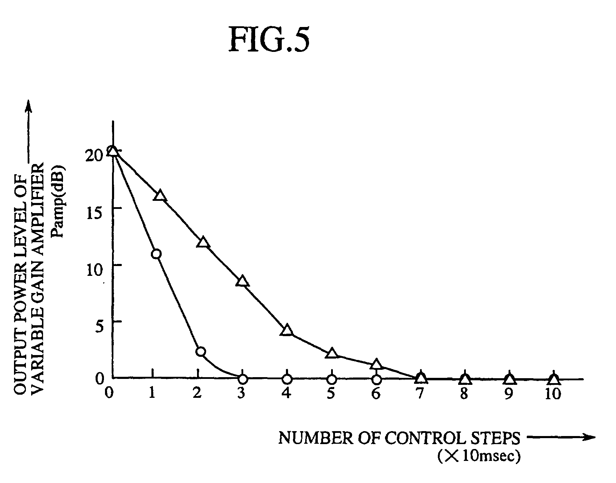

Fig. 5 is a graph showing a step response characteristic of automatic gain control according to the first embodiment. In this step response, it is assumed that the resolution of the A/D converter 11 is 7 bits and the input power level Pin is increased in steps by 20 dB. In this step response, the number of control steps is plotted horizontally, where one step lasts a period of 10 msec. The output power level Pamp of the variable gain amplifier is plotted vertically. In the step response characteristic, successive steps of control according to the related art, where the first coefficient α1 and the second coefficient α2 are both 1, are plotted using symbols Δ. The control according to the first embodiment, where the first coefficient α1 is 0.5 and the second coefficient α2 is 1.0, is represented by plot symbols O. As evidenced from Fig. 5, the first embodiment ensures that the output power level of the variable gain amplifier 10 drops to the reference level Pref in a period of time half that of the related art.

Since the gain control process is implemented by the DSP 12, occurrence of noise on a signal line is avoided in contrast to a configuration in which the gain control process is implemented by a plurality of hardware sets. Thus, the gain control is more successful.

In the description given above, the demodulating process and the gain control process are performed by a software process using a single DSP. Alternatively, the demodulating process and the gain control process may be performed using separate hardware sets.

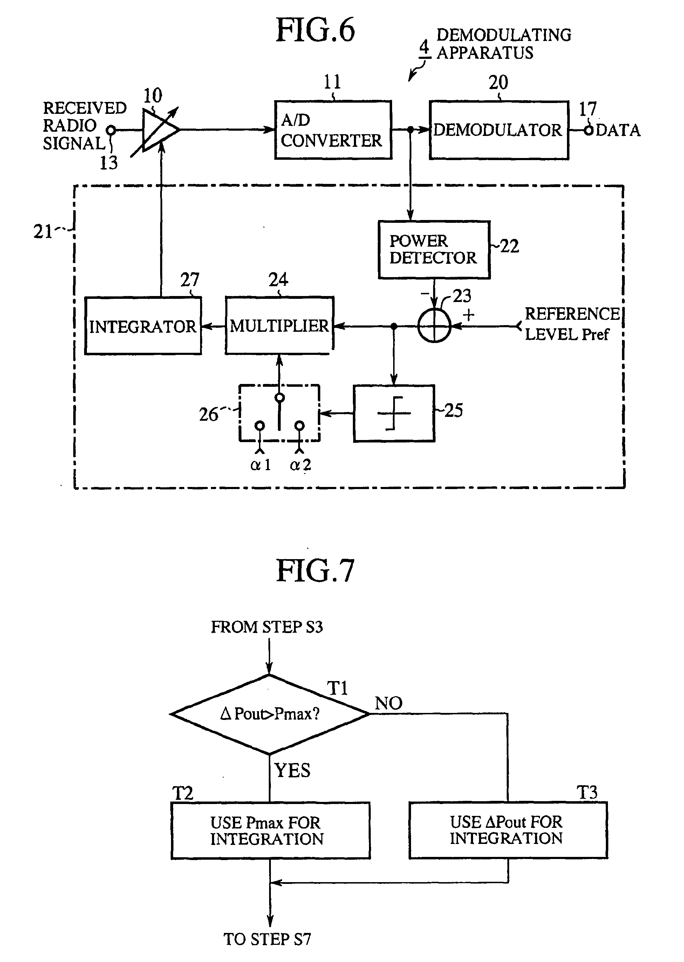

Fig. 6 is a block diagram showing a construction of the demodulating apparatus 4 in which the demodulating process and the gain control process are implemented by respective hardware sets. The demodulating apparatus 4 comprises the variable gain amplifier 10, the A/D converter 11, a demodulator 20 and an automatic gain control circuit 21. The automatic gain control circuit 21 is provided with a power detector 22, a subtractor 23, a multiplier 24, a comparator 25, a switch 26 and an integrator 27.

The power detector 22 detects the output power level Pout of the received radio signal output from the A/D converter 11. The subtractor 23 determines a differential value ΔPout between the output power level Pout and the reference level Pref. The multiplier 24 multipliers the differential value ΔPout by a coefficient α. The coefficient α is one of the first coefficient α1 and the second coefficient α2 selected by the switch 26. The selection is based on the output from the comparator 25. The comparator 25 detects the polarity of the differential value ΔPout. When the differential value ΔPout is negative, the comparator 25 controls the switch 26 to select the first coefficient α1. When the differential value ΔPout is positive, the comparator 25 controls the switch 26 to select the second coefficient α2. The integrator 27 integrates the differential value ΔPout after multiplication so as to determine the gain. The integrator then supplies the gain to the variable gain amplifier 10.

Thus, according to the construction described above, gain control is performed by hardware so that the control is accomplished in a short period of time.

### Second embodiment

Fig. 7 is a flowchart showing a gain control process in the DSP 12 to which an automatic gain control method according to a second embodiment of the present invention is applied. Steps T1-T3 of Fig. 7 are designed for substitution for steps S4-S8 of Fig. 3.

In the first embodiment, the magnitude of variation in gain is determined by multiplying the differential value ΔPout between the output power level Pout and the reference level Pref by the first coefficient α1 or the second coefficient α2. In contrast, according to the second embodiment, the magnitude of variation in gain is determined by limiting the differential value ΔPout to confine it in a predetermined range.

More specifically, after determining the differential value ΔPout between the output power level Pout and the reference level Pref, the DSP 12 according to the second embodiment limits the differential value ΔPout to confine it in a predetermined range (steps T1-T3). The range extends below a predetermined upper limit Pmax (for example, Pmax=+3 dB: first marginal value). The DSP 12 makes a determination as to whether the differential value ΔPout is greater than the upper limit Pmax (step T1). When it is determined that the differential value ΔPout is greater than the upper limit Pmax, the DSP 12 designates the upper limit Pmax as the differential value ΔPout for use in the subsequent integration process (step T2). When it is determined that the differential value ΔPout is smaller than the upper limit Pmax, the DSP 122 uses the differential value in the subsequent integration step (step T3).

Thus, when the differential value ΔPout is greater than the upper limit Pmax, the magnitude of variation in gain is limited. That the differential value ΔPout is greater than the upper limit Pmax means that the output power level Pout of the variable gain amplifier 10 is smaller than the reference level Pref so that it is necessary to increase the gain of the variable gain amplifier 10. In this way, the magnitude of variation in gain in the increasing direction of gain is limited. With this, any abrupt increase in the output power level Pout of the variable gain amplifier 10 is controlled.

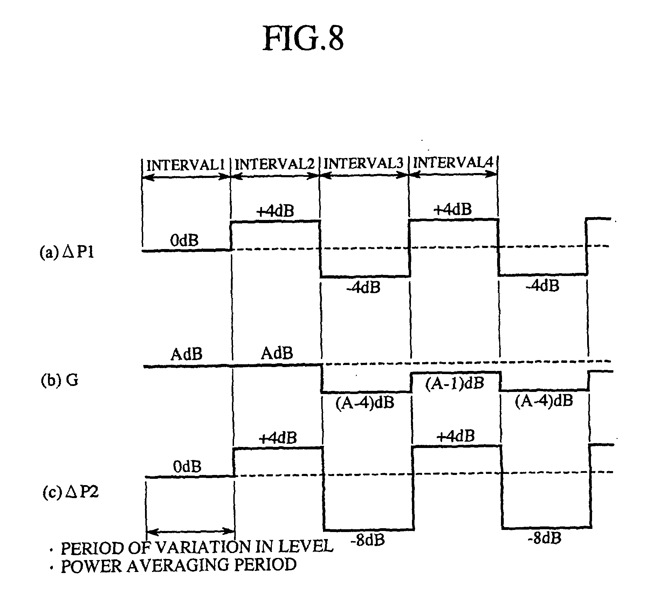

As in Fig. 4, (a), (b) and (c) of Fig. 8 respectively show the difference ΔP1, gain G and the difference ΔP2. In Fig. 8, it is assumed that the period of variation in level caused by fading matches the power averaging period.

When the input power level Pin in interval 1 is equal to the reference level Pref, i.e., when the difference ΔP1 is 0 dB, gain G for interval 2 is set to A dB equal to the previous level of gain G for interval 1. When the input power level is increased to a level 4 dB higher than the reference level in interval 2, the output power level Pamp of the variable gain amplifier 10 in interval 2 is increased to a level 4 dB higher than that of interval 1, since gain G for interval 2 remains A dB, the same level for interval 1. Therefore, it is necessary to cancel the increase in interval 3. Since the variation is in the decreasing direction of gain, no limit is imposed on the differential value ΔPout so that (A-4)dB, which directly corresponds to the differential value ΔPout, is set as gain G of the variable gain amplifier.

When the input power level Pin drops to a level 4 dB lower than the reference level in interval 3, the output power level of the variable gain amplifier drops to a level 8 dB lower than the reference level, since gain G for interval 3 is (A-4)dB. Accordingly, it is necessary to increase the output power level Pamp of the variable gain amplifier in interval 4. Since the variation is in the increasing direction of gain, the upper limit Pmax is imposed on the differential value Pout so that gain G of the variable gain amplifier 10 for interval 4 is A-4+3=(A-1)dB.

When the input power level Pin is increased to a level 4 dB higher than the reference level Pref in interval 4, the output power level Pamp of the variable gain amplifier 10 is increased to a level 3dB higher than the reference level Pref in interval 4, since gain G for interval 4 is (A1)dB. Thus, increase in the output power level Pamp of the variable gain amplifier 10 is suppressed as compared to a case where the magnitude of variation in gain is 8 dB.

According to the second embodiment, the variation in gain in the increasing direction is controlled to be smaller than that of the decreasing direction so that the magnitude of variation in gain in the increasing direction is suppressed. Accordingly, similar advantages provided by the first embodiment are also provided by the second embodiment. That is, even when the period of variation in level caused by fading matches the power averaging period, and when the input power level Pin is increased abruptly in steps as a result of, for example, exiting from a tunnel, the magnitude of increase in the output power level Pout of the variable gain amplifier 10 is suppressed.

In further accordance with the second embodiment, it is only necessary to perform the mere comparison process instead of the multiplication process, which may be relatively complex, so that the process is simplified.

In the description given above, the demodulating process and the gain control process are performed by a software process using a single DSP. Alternatively, the demodulating process and the gain control process may be implemented by separate hardware sets.

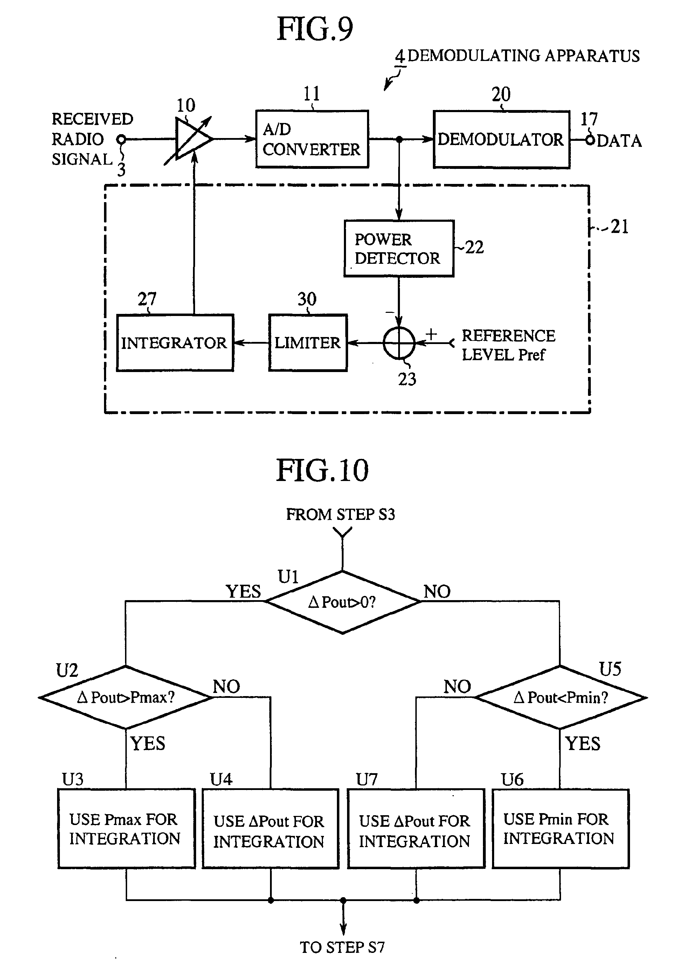

Fig. 9 is a block diagram showing a construction of the demodulating apparatus 4 in which the demodulating process and the gain control process are implemented by separate hardware sets. In the demodulating apparatus 4, a limiter 30 is provided between the subtractor 23 and the integrator 27 instead of the multiplier 24, the comparator 25 and the switch 26 of Fig. 6. The limiter 30 provides the upper limit Pmax which is imposed on the differential value ΔPout. According to this construction, gain control is performed by hardware so that the control is accomplished in a short period of time.

In the description given above, only the upper limit Pmax is set. Alternatively, the lower limit Pmin (second limit) may also be set. It is of course ensured that the absolute value of the lower limit Pmin is larger than the upper limit Pmax. In other words, the difference between the lower limit Pmin and the reference level Pref is ensured to be larger than the difference between the upper limit Pmax and the reference level Pref. With this, the magnitude of variation in gain in the increasing direction is ensured to be smaller than that of the decreasing direction.

Fig. 10 is a flowchart showing a part of the gain control process where the lower limit Pmin is set. Steps U1-U7 in Fig. 10 are designed for substitution for steps S4-S8 of Fig. 3.

The DSP 12 determines the differential value ΔPout between the output power level and the reference level Pref and determines the polarity of the differential value ΔPout. More specifically, the DSP 12 determines whether the differential value ΔPout is positive or negative (step U1). If the differential value ΔPout is positive, it is determined that the output power level Pamp of the variable gain amplifier 10 is lower than the reference level Pref. Since the gain of the variable gain amplifier 10 is due in this case, the DSP 12 imposes the upper limit to the differential value ΔPout (steps U2-U4).

More specifically, the DSP 12 makes a determination as to whether the differential value ΔPout is larger than the upper limit Pmax (step U2). If the differential value ΔPout is larger than the upper limit Pmax, the DSP 12 uses the upper limit Pmax, instead of the differential value ΔPout, for the integration process, so as to suppress the magnitude of increase in gain (step U3). If the differential value ΔPout is smaller than the upper limit Pmax, it is not necessary to suppress the magnitude of increase in gain so that the DSP 12 uses the differential value ΔPout for the integration process (step U4).

If it is determined in step U1 that the differential value ΔPout is negative, it is determined that the output power level of the variable gain amplifier 10 is higher than the reference level Pref. Since it is necessary to reduce the gain of the variable gain amplifier 10 in this case, the DSP 12 imposes the lower limit to the differential value ΔPout (step U5-U7).

More specifically, the DSP 12 makes a determination as to whether the differential value ΔPout is smaller than the lower limit Pmin (step U5). If the differential value ΔPout is smaller than the lower limit Pmin, the DSP 12 uses the lower limit Pmin, instead of the differential value ΔPout, for the integration process, so as to suppress the magnitude of decrease in gain (step U6). If the differential value ΔPout is larger than the lower limit Pmin, it is not necessary to suppress the magnitude of decrease in gain so that the DSP 12 uses the differential value ΔPout for the integration process (step U7).

### Third embodiment

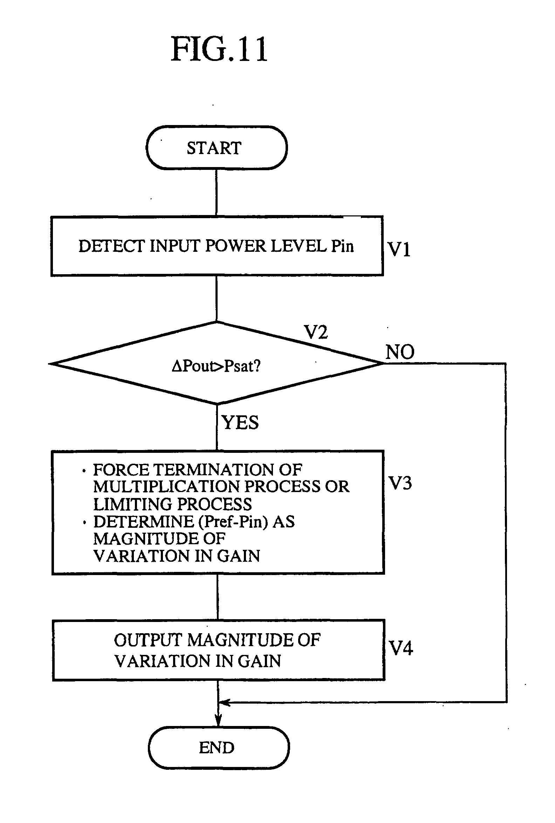

Fig. 11 is a flowchart showing a saturation gain control process performed by a DSP in the event of saturation, to which process an automatic gain control method according to a third embodiment of the present invention is applied.

In the second embodiment, the magnitude of variation in gain is controlled by limiting the differential value ΔPout between the reference level Pref and the input power level to be below the upper limit Pmax. When the differential value ΔPout is a significantly small negative value, i.e, when the output power level Pout is higher than a predetermined threshold level, it may be considered that saturation occurs in the A/D converter 11. According to the third embodiment, when the differential value ΔPout is below a predetermined saturation level, feed-forward control, instead of feed-back control, is used to cancel the saturation in the A/D converter 11 efficiently.

More specifically, the DSP 12 performs a gain control process triggered by saturation, as an interruption in the gain control process of Fig. 3, Fig. 6 or Fig. 10. The DSP 12 detects the input power level Pin (step V1). The dynamic range used by the DSP 12 in detecting the input power level Pin is in the neighborhood of a power level range in which saturation of the A/D converter begins to occur. With this procedure, the DSP 12 successfully detects the input power level Pin at which the A/D converter 11 saturates.

The DSP 12 also makes a determination as to whether the A/D converter 11 saturates, based on the differential value ΔPout between the output power level Pout and the reference level Pref, the differential value ΔPout being determined as a result of the gain control process of Fig. 3. More specifically, the DSP 12 makes a determination as to whether the differential value ΔPout is smaller than a saturation value Psat (step V2). The saturation value Psat corresponds to a difference between the reference level Pref and the output power level Pout at which the A/D converter 11 begins to saturate.

If the differential value ΔPout is smaller than the saturation value Psat, it is considered that the A/D converter 11 is in a saturated state. The DSP 12 then enforces termination of step S4 and subsequent steps of Fig. 3, step T1 and subsequent steps of Fig. 7, or step U1 and subsequent steps of Fig. 10, and proceeds to determine a magnitude of variation in gain, based on the reference level Pref and the input power level (step V3). More specifically, the DSP 12 determines the magnitude of variation in gain as (Pref-Pin)dB.

The DSP 12 supplies the magnitude of variation in gain thus determined to the variable gain amplifier 10 (step V4). With this, the difference between the input power level Pin and the reference level Pref is subtracted from the input power level Pin, so that the output power level of the variable gain amplifier 10 is equal to the reference level Pref. The DSP 12 retains the magnitude of variation in gain determined in step V3 to use it as an integral value used in the subsequent gain control process.

In contrast, if it is determined that the differential value ΔPout is larger than the saturation value Psat, it is considered that the A/D converter 11 is not in a saturated state. The DSP 12 performs step S4 and subsequent steps of Fig. 3, step T1 and subsequent steps of Fig. 7 or step U1 and subsequent steps of Fig. 10 in a normal manner.

Accordingly, the third embodiment ensures that, when the A/D converter 11 saturates, the magnitude of variation in gain is determined by subtracting the input power level Pin prior to gain control from the reference level Pref. Accordingly, in contrast with the first embodiment where the gain is decreased by a relatively small level even when the A/D converter 11 saturates, the third embodiment ensures that the output power level Pamp of the variable gain amplifier 10 drops to the reference level Pref rapidly when the A/D converter 11 saturates. Accordingly, saturation of the A/D converter 11 is cancelled in a shorter period of time than the first embodiment.

In the description given above, it is assumed that the demodulating process and the gain control process are performed by a software process using a signal DSP 12. Alternatively, the demodulating process and the gain control process may be performed by separate hardware sets.

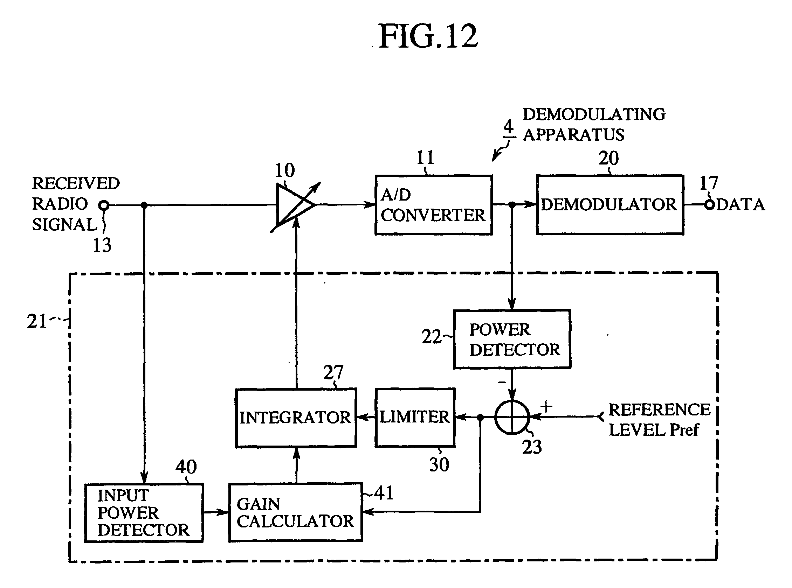

Fig. 12 is a block diagram showing a construction of the demodulating apparatus 4 in which the demodulating process and the gain control process are implemented by separate hardware sets. In the demodulating apparatus 4, an input power detector 40 and a gain calculator 41 are provided in addition to the construction of Fig. 9. The input power detector 40 detects the input power level Pin of the received radio signal input to the variable. gain amplifier 10 and supplies the detected input power level to the gain calculator 41.

The gain calculator 41 receives the 'differential value ΔPout output from the subtractor 23 and the input power level Pin output from the input power detector 40 so as to set the magnitude of variation in gain calculated therein at the output of the integrator 27. More specifically, the gain calculator 41 makes a determination as to whether the differential value ΔPout is smaller than the saturation value Psat. If the determination is positive, the gain calculator 41 obtains the magnitude of variation in gain by subtracting the input power level Pin from the reference level Pref. According to the construction described above, gain control is performed by hardware so that the control is accomplished in a short period of time.

### Fourth embodiment

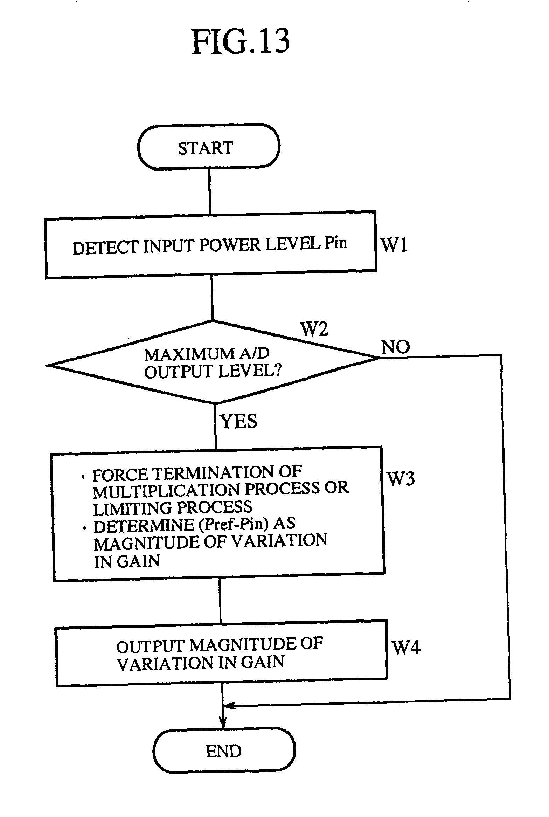

Fig. 13 is a flowchart showing a saturation gain control process performed by a DSP in the event of saturation, to which process an automatic gain control method according to a fourth .embodiment of the present invention is applied.

In the third embodiment, a determination is made as to whether the A/D converter 11 saturates, based on the differential value ΔPout between the output power level Pout and the reference level Pref. In contrast, in the fourth embodiment, the determination as to saturation of the A/D converter 11 is made by directly examining the output from the A/D converter 11.

More specifically, the DSP 12 detects the input power level Pin (step W1). The DSP 12 determines whether the level of the received radio signal output from the A/D converter 11 is a maximum output level of the A/D converter 11 (step W2). For example, the maximum output level is +127 in the case of an 8-bit A/D converter 11.

When the received radio signal is at the maximum output level, it is considered that the A/D converter 11 is in a saturated state. In a similar configuration as the third embodiment, the DSP 12 enforces termination of step S4 and subsequent steps of Fig. 3, step T1 and subsequent steps of Fig. 7, or step U1 and subsequent steps of Fig. 10. The DSP 12 also determines the magnitude of variation in gain, based on the reference level Pref and the input power level Pin (step W3). The magnitude of variation in gain thus determined is supplied to the variable gain amplifier 10 (step W4).

If the level of the received radio signal output from the A/D converter 11 is not the maximum level, it is considered that the A/D converter 11 is not in a saturated state. The DSP 12 performs step S4 and subsequent steps of Fig. 3, step T1 and subsequent steps of Fig. 7 or step U1 and subsequent steps of Fig. 10 in a normal manner.

Accordingly, the fourth embodiment ensures that, when the A/D converter 11 saturates, the magnitude of variation in gain is determined, based on the input power level Pin prior to gain control, so that the output power level Pamp of the variable gain amplifier 10 is decreased to the reference level Pref in a short period of time. Accordingly, saturation of the A/D converter 11 is cancelled in a short period of time.

In the description given above, the demodulating process and the gain control process are performed by a software process using a single DSP 12. Alternatively, the demodulating process and the gain control process may be implemented by separate hardware sets.

Fig. 14 is a block diagram showing a construction of the demodulating apparatus 4 in which the demodulating process and the gain control process are implemented by separate hardware sets. In this demodulator, the input power detector 40, a gain calculator 50 and a saturation detector 51 are provided in addition to the construction of Fig. 9. The saturation detector 51 determines whether the A/D converter 11 is in a saturated state, based on the received radio signal output from the A/D converter 11. When saturation is detected, the saturation detector 11 notifies the gain calculator 50 accordingly. Unlike the third embodiment, the gain calculator 50 is not provided with saturation detection function. When notified of the detection of saturation, the gain calculator 50 calculates the magnitude of variation in gain, based on the reference level Pref and the input power level Pin. According to the construction described above, gain control is performed by hardware so that the control is accomplished in a short period of time.

In the description given above, determination as to saturation of the A/D converter 11 is made, based on the output of the A/D converter 11. Alternatively, saturation of the A/D converter 11 may be detected, based on the input to the A/D converter 11. More specifically, the gain calculator 50 may determine whether the A/D converter 11 is in a saturated state, based on whether the level of the received radio signal input to the A/D converter 11 is the upper limit of the dynamic range of the A/D converter 11. If the dynamic range is -5V∼+5V, the A/D converter 11 is determined to be in a saturated state if the received signal is +5V.

### Other embodiments

The present invention is not limited to the embodiments described above. An assumption in the description given above of the embodiments is that the present invention is applied to the mobile station 1. However, the present invention may be equally adapted to the base station 2.

## Claims

1. An automatic gain control method for automatically controlling a gain of a variable gain amplifier, based on a difference between a predetermined reference level and a power level of a received radio signal digitized by an analog-to-digital converter subsequent to amplification by the variable gain amplifier, wherein the gain of the variable gain amplifier is controlled such that a magnitude of variation in gain for a case where the power level is lower than the reference level is controlled to be smaller than that of a case where the power level is higher than the reference level.

2. An automatic gain control method for automatically controlling a gain of a variable gain amplifier, based on a difference between a reference level and a power level of a received radio signal digitized by an analog-to-digital converter subsequent to amplification by the variable gain amplifier, comprising the steps of:
detecting a power level of a received radio signal output by the variable gain amplifier;
determining a difference between the detected power level and a predetermined reference level;
determining, when the difference indicates that the power level is higher than the reference level, a first magnitude of variation in gain, based on the difference;
determining, when the difference indicates that the power level is lower than the reference level, a second magnitude of variation in gain, which is smaller than the first magnitude of variation in gain, based on the difference; and
controlling the gain of the variable gain amplifier, based on one of the first magnitude of variation in gain and the second magnitude of variation in gain.

3. The automatic gain control method according to claim 2, wherein the first magnitude of variation in gain is determined by multiplying a predetermined first coefficient by the difference, and the second magnitude of variation in gain is determined by multiplying a predetermined second coefficient, which is smaller than the first coefficient, by the difference.

4. The automatic gain control method according to claim 2, wherein the first magnitude of variation in gain is determined by limiting the difference to be within a predetermined first limiting range, and the second magnitude of variation is determined by limiting the difference to be within a predetermined second limiting range wider than the first limiting range.

5. The automatic gain control method according to any of claims 1 through 4, comprising the steps of:
detecting an input power level by detecting a power level of a received radio signal before being input to the variable gain amplifier;
detecting whether the analog-to-digital converter saturates;
preventing execution of steps for determining the first magnitude of variation in gain and the second magnitude of variation in gain when saturation of the analog-to-digital converter is detected, and designating a difference obtained by subtracting the input power level from the reference level as a target magnitude of variation in gain; and
controlling the gain of the variable gain amplifier, based on the target magnitude of variation in gain.

6. The automatic gain control method according to claim 5, wherein saturation of the A/D converter is detected when an output or an input of the A/D converter is at a predetermined maximum level.

7. An automatic gain control processor comprising a variable gain amplifier, an analog-to-digital converter and connection terminals connected to said variable gain amplifier and said analog-to-digital converter, for automatically controlling a gain of said variable gain amplifier via said connection terminals, based on a difference between a power level of a received radio signal input from said analog-to-digital converter via said connection terminals and a reference level, wherein the gain of said variable gain amplifier is controlled such that a magnitude of variation in gain for a case where the power level is lower than the reference level is controlled to be smaller than that of a case where the power level is higher than the reference level.

8. A demodulating apparatus comprising:
a variable gain amplifier for amplifying a received radio signal;
an analog-to-digital converter for digitizing the received radio signal amplified by said variable gain amplifier and outputting the digital signal; and
an automatic gain control processor executing a step of demodulating the received radio signal output from said analog-to-digital converter, and a step of controlling a gain of said variable gain amplifier such that a magnitude of variation in gain for a case where a power level of the received radio signal output from said analog-to-digital converter is lower than a reference level is controlled to be smaller than that of a case where the power level is higher than the reference level.
